# EUROPEAN PATENT APPLICATION

(11) **EP 4 625 476 A1**
(43) Date of publication of application: **01.10.2025**
(21) Application number: 23923331.5
(22) Date of filing: 23.02.2023
(51) Int. Cl.: H01L 21/335

(54) **PREPARATION METHOD FOR GALLIUM NITRIDE DEVICE, AND GALLIUM NITRIDE HEMT**

(71) Applicant: Jiangsu Corenergy Semiconductor Co., Ltd., Suzhou, Jiangsu 215000 (CN)
(72) Inventor: LI, Yiheng, Suzhou, Jiangsu 215000 (CN); ZHU, Tinggang, Suzhou, Jiangsu 215000 (CN); WU, Leke, Suzhou, Jiangsu 215000 (CN); XIA, Yuanyang, Suzhou, Jiangsu 215000 (CN); WEI, Hongyuan, Suzhou, Jiangsu 215000 (CN); WANG, Qiang, Suzhou, Jiangsu 215000 (CN); QIN, Jiaming, Suzhou, Jiangsu 215000 (CN); HUANG, Keqiang, Suzhou, Jiangsu 215000 (CN)
(74) Representative: De Vries & Metman
(86) International application number: PCT/CN2023/077794
(87) International publication number: WO 2024/174151

(57) **Abstract**

The present invention relates to the field of semiconductors, and disclosed are a preparation method for a gallium nitride device, and a gallium nitride HEMT. The preparation method for the gallium nitride device comprises the following steps: epitaxially growing multiple layers on a substrate by means of chemical vapor deposition, an interlayer comprising an active device channel region; grinding the entire rear surface of the substrate; machining a hole structure and/or a groove structure in a local region on the rear surface of the substrate after grinding, the local region and the active device channel region being opposite each other on an upper side and a lower side of the substrate; attaching the back surface of the substrate to a packaged chip by means of conductive solder paste. The present invention can further increase heat dissipation performance of the gallium nitride device, while also ensuring the strength of the device, and preventing problems with the device such as warping and cracking.

## Description

### TECHNICAL FIELD

The invention relates to the field of semiconductors, and particularly relates to a preparation method for a gallium nitride device, and a gallium nitride HEMT.

### BACKGROUND

Gallium nitride HEMT (high electron mobility transistor) structures are typically grown epitaxially by MOCVD (Metal-organic Chemical Vapor Deposition) on substrates (such as silicon, silicon carbide, sapphire or even single crystal gallium nitride) available in the market. Various low voltage, high voltage or high frequency gallium nitride HEMT devices used for consumer/industrial/automotive power switching and radio frequency amplifier are manufactured on 4 to 8 inch wafers by CMOS compatible process modules in wafer fabs. The choice of substrate for a specific application depends on many factors, wherein the thermal conductivity of the substrate is a key factor.

The disclosure of the above background is only used to assist in understanding the inventive concept and technical solutions of the invention, and does not necessarily belong to the prior art of the patent invention, nor necessarily give technical teaching; in the absence of explicit evidence that the above content has been disclosed before the filing date of the patent invention, the above background should not be used to evaluate the novelty and inventiveness of the invention.

### SUMMARY

An object of the invention is to provide a preparation method for a gallium nitride device and a gallium nitride HEMT, which can improve a heat dissipation performance of the gallium nitride device while ensuring strength thereof.

To achieve the above object, the invention adopts the following technical scheme:
a preparation method for a gallium nitride device, including the following steps:
epitaxially growing a plurality of layers on a substrate by chemical vapor deposition, an active device channel area being provided between the plurality of layers;
grinding a whole back surface of the substrate;
machining out a hole structure and/or groove structure at a local area of the back surface of the substrate, the local area and the active device channel area being located on upper and lower sides of the substrate and opposite to each other;
attaching the back surface of the substrate to a packaging chip by conductive solder paste.

Further, according to any one of the above technical solutions or the combination of the above technical solutions, the preparation method further includes that the substrate is a sapphire substrate, and a thickness of a machining position at the local area of the sapphire substrate is less than one fifth of a thickness of the sapphire substrate after grinding the whole back surface.

Further, according to any one of the preceding technical solutions or the combination of the preceding technical solutions, the preparation method further includes that the hole structure and/or groove structure are machined at the local area by a pulsed laser, so that the thickness of the machining position at the local area of the sapphire substrate is between 1 and 100 µm, or between 1 and 80 µm, or between 1 and 60 µm, or between 1 and 40 µm, or between 1 and 20 µm, or between 1 and 10 µm.

Further, according to any one of the preceding technical solutions or the combination of the preceding technical solutions, the preparation method further includes that the hole structure and/or groove structure machined at the local area have a diameter and/or width between 0.1 and 1 µm.

Further, according to any one of the preceding technical solutions or the combination of the preceding technical solutions, the preparation method further includes that the pulsed laser has a pulse width between 5 femtoseconds and 100 picoseconds, and a power density greater than 3 J/cm².

Further, according to any one of the preceding technical solutions or the combination of the preceding technical solutions, the preparation method further includes that a thickness of the sapphire substrate before grinding the whole back surface is greater than 300 µm, and the thickness of the sapphire substrate after grinding the whole back surface is between 100 µm and 300 µm.

Further, according to any one of the preceding technical solutions or the combination of the preceding technical solutions, the preparation method further includes that the substrate is a silicon substrate or a SiC substrate, and the hole structure and/or groove structure are machined at the local area by a chemical method of wet etching or dry etching.

Further, according to any one of the preceding technical solutions or the combination of the preceding technical solutions, the preparation method further includes that a plurality of active device channels are arranged in the active device channel area;
hole structures and/or groove structures are machined only at the local area opposite to every active device channel.

Further, according to any one of the preceding technical solutions or the combination of the preceding technical solutions, the epitaxial growing of a plurality of layers on the substrate by the chemical vapor deposition method includes:
growing a GaN or AlGaN buffer layer on the substrate;
growing a GaN channel layer on the buffer layer;
growing an AlGaN barrier layer on the GaN channel layer, and forming a 2DEG at a heterojunction interface between the GaN channel layer and the AlGaN barrier layer;
etching down from the AlGaN barrier layer to the GaN channel layer to form two grooves, and arranging a source electrode and a drain electrode in the grooves, respectively; and arranging a gate electrode on the AlGaN barrier layer.

According to another aspect of the invention, the invention provides a gallium nitride HEMT, including a packaging chip and a semiconductor module conductively connected thereto, wherein the semiconductor module includes:
a substrate, a back surface thereof being attached to the packaging chip by conductive solder paste;
a GaN or AlGaN buffer layer epitaxially grown on the substrate by MOCVD;
a GaN channel layer grown on the buffer layer;
an AlGaN barrier layer grown on the GaN channel layer, and a 2DEG being formed at a heterojunction interface between the GaN channel layer and the AlGaN barrier layer;
a source electrode, a drain electrode and a gate electrode of the transistor;
wherein the source electrode and the drain electrode are disposed in through-grooves of the AlGaN barrier layer, and the gate electrode is disposed on the AlGaN barrier layer.
a hole structure and/or groove structure are machined at a local area on a back surface of the substrate, wherein the local area and the active device channel area at the 2DEG are located on upper and lower sides of the substrate and opposite to each other, and a thickness of a machined position at the local area of the substrate is less than half of a thickness of an un machined position of the substrate.

Further, according to any one or combination of the preceding technical solutions, the substrate is a sapphire substrate, and the thickness of the machined position at the local area of the sapphire substrate is less than one fifth of the thickness of the unmachined position of the sapphire substrate.

Further, according to any one or combination of the preceding technical solutions, the thickness of the machined position at the local area of the sapphire substrate is 1 and 100 µm, or between 1 and 80 µm, or between 1 and 60 µm, or between 1 and 40 µm, or between 1 and 20 µm, or between 1 and 10 µm

Further, according to any one or combination of the preceding technical solutions, a diameter of the hole structure and/or width of the groove structure machined at the local area is between 0.1 and 1 µm.

Further, according to any one or combination of the preceding technical solutions, the thickness of the unmachined position of the substrate is between 100 and 300 µm.

Further, according to any one or combination of the preceding technical solutions, the hole structure and/or groove structure are machined at the local area by a pulsed laser, wherein the pulsed laser has a laser pulse width between 5 femtoseconds and 100 picoseconds, and wherein the pulsed laser has a power density greater than 3 J/cm².

Further, according to any one or combination of the preceding technical solutions, the substrate is a silicon substrate or a SiC substrate, and the hole structure and/or groove structure are machined at the local area by a chemical method of wet etching or dry etching.

Further, according to any one or combination of the preceding technical solutions, a plurality of active device channels are arranged in the active device channel area;
hole structures and/or groove structures are machined only at the local area opposite to every active device channel.

The technical solutions of the invention have the following beneficial effects:
a. the preparation method for a gallium nitride device of the invention can improve the heat dissipation performance of the device while ensuring the strength of the device by machining out a hole structure and/or groove structure at the local area on the back surface of the substrate after grinding, the local area and the active device channel area being located on the upper and lower sides of the substrate and opposite to each other, and the thickness of the processing position at the local area of the substrate being smaller than the thickness of the substrate after grinding the whole back surface;
b. the preparation method for a gallium nitride device of the invention machines out a hole structure and/or groove structure at the local area on the sapphire substrate by using a pulse laser, and the processing effect is good and the cost is low;
c. the gallium nitride HEMT of the invention can be a device using silicon or silicon carbide as a substrate or a device using sapphire as a substrate, and the local area of the back surface of the substrate is provided with a hole structure and/or groove structure, so that the gallium nitride HEMT can have good heat dissipation performance and reliable strength and is not prone to warping and breaking.

### BRIEF DESCRIPTION OF DRAWINGS

In order to more clearly illustrate the technical solutions in the embodiments of the present invention or in the conventional art, the following briefly describes the drawings needed in the embodiments or the conventional art description, and obviously, the drawings in the following description are only some embodiments described in the present invention, and other drawings can also be obtained according to these drawings without creative labor for a person skilled in the art.
FIG. 1 is a flow chart of a preparation method for a gallium nitride device provided by an exemplary embodiment of the present invention;
FIG. 2 is a schematic structural diagram of a substrate before grinding the whole back surface in a process of preparing a gallium nitride device provided by an exemplary embodiment of the present invention;
FIG. 3 is a schematic structural diagram of a substrate after grinding the whole back surface in a process of preparing a gallium nitride device provided by an exemplary embodiment of the present invention;
FIG. 4 is a schematic structural diagram of a substrate with a groove structure machined at a local area of the back surface thereof based on the gallium nitride device shown in FIG. 3;
FIG. 5 is a schematic structural diagram of a gallium nitride HEMT (the back surface of the substrate is provided with conductive solder paste) provided by an exemplary embodiment of the present invention;
FIG. 6 is a schematic diagram of active device channels and a local area on a gallium nitride device provided by an exemplary embodiment of the present invention.

In the drawings, reference signs include: 11 - substrate; 111 - local area; 12 - buffer layer; 13 - GaN channel layer; 14 - AlGaN barrier layer; 15 - 2DEG; 21 - source electrode of transistor; 22 - drain electrode of transistor; 23 - gate electrode of transistor; and 31 - conductive solder paste.

### DETAILED DESCRIPTION

In the following, the technical solutions in the embodiments of the present invention will be clearly and completely described in combination with the accompanying drawings in the embodiments of the present invention. Obviously, the described embodiments are only part of the embodiments of the present invention, rather than all the embodiments. Based on the embodiments of the present invention, all the other embodiments obtained by those skilled in the art without creative labor should belong to the protection scope of the present invention.

It should be understood that the terms "first", "second", and so on in the specification and claims of the present invention and the above drawings are used to distinguish similar objects, and do not have to be used to describe a specific order or sequence. It should be understood that the data thus used can be interchanged under appropriate circumstances, so that the embodiments of the invention described herein can be implemented in an order other than that illustrated or described herein. In addition, the terms "include" and "have" and any variations thereof are intended to cover non-exclusive inclusions, for example, processes, methods, devices, products, or apparatuses including a series of steps or units do not have to be limited to those steps or units clearly listed, but can include other steps or units not clearly listed or inherent to these processes, methods, products, or apparatuses.

To improve the thermal conductivity of the substrate, the conventional practice is to grind the substrate to a very thin thickness. However, there is a minimum thickness limit for back surface grinding of the substrate, because if the substrate becomes too thin, wafer warpage and cracking can occur, especially for larger size wafers. Typically, for a 6-inch gallium nitride HEMT epitaxial wafer, the final substrate needs to have a thickness of around 300 µm to avoid wafer breakage. However, for certain substrates, such as sapphire, which has poor thermal conductivity compared to other materials such as Si, SiC, and GaN, the conventional substrate grinding solution to improve thermal conductivity does not solve the problem of thermal induced performance degradation or even failure of devices prepared on sapphire substrates.

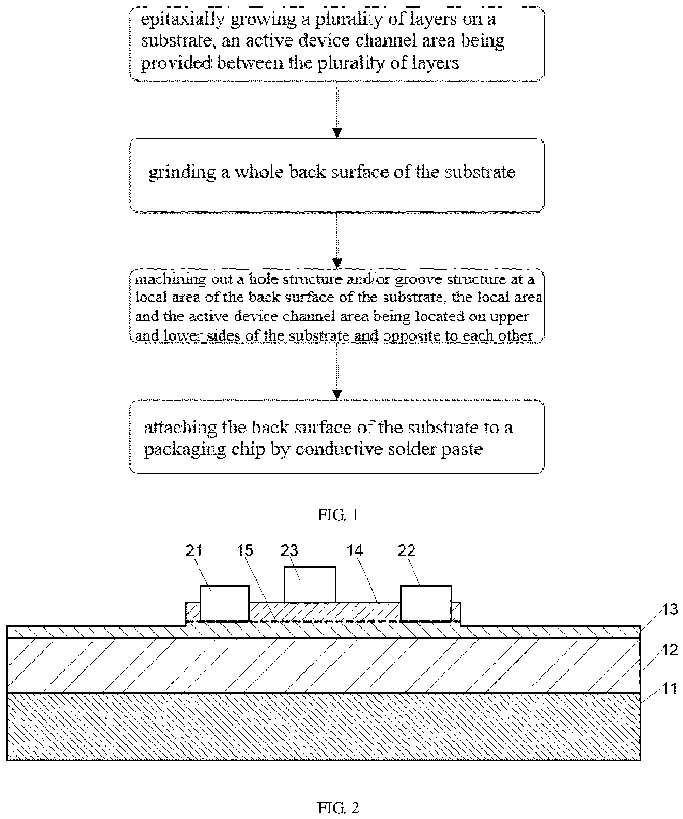

In one embodiment of the present invention, a preparation method for a gallium nitride device is provided, which enhances the heat dissipation performance of the active device while ensuring the strength thereof, thereby avoiding wafer warpage and cracking. Referring to FIG. 1, the preparation method includes the following steps:
referring to FIG. 2, epitaxially growing a plurality of layers on a substrate 11 (e.g., a silicon substrate, a silicon carbide substrate, a sapphire substrate, or the like) by chemical vapor deposition, including:
growing a buffer layer 12 on the substrate 11, the buffer layer 12 being a GaN or AlGaN buffer layer;
growing a GaN channel layer 13 on the buffer layer 12;
growing an AlGaN barrier layer 14 on the GaN channel layer 13, and a 2DEG 15 being formed at a heterojunction interface between the GaN channel layer 13 and the AlGaN barrier layer 14;
etching down from the AlGaN barrier layer 14 to the GaN channel layer 13 to form two grooves, and arranging the source electrode 21 and the drain electrode 22 in the grooves respectively; and arranging the gate electrode 23 on the AlGaN barrier layer 14.

An active device channel area is provided between the plurality of layers, and a plurality of active device channels may be arranged in the active device channel area.

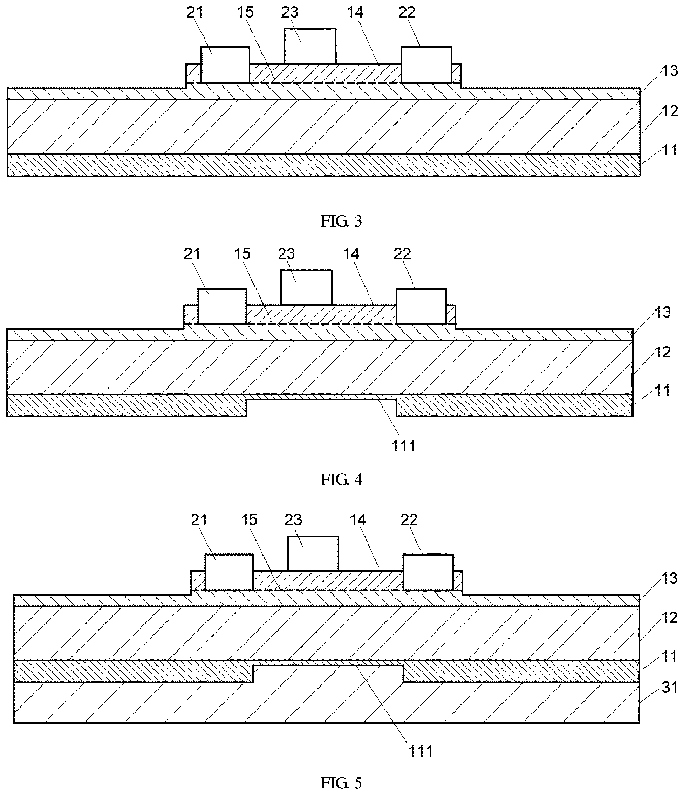

The whole back surface of the substrate shown in FIG. 2 is grinded, and the grinded gallium nitride device is shown in FIG. 3, so that the thickness is thinned, for example, the global thickness of the substrate 11 is reduced to one half or one third of the original thickness.

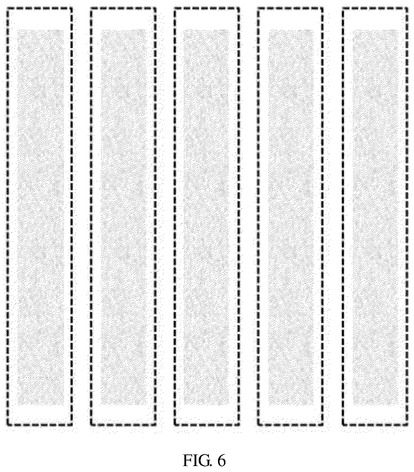

Referring to FIG. 4, hole structures and/or groove structures are machined at a local area 111 of the back surface of the grinded substrate 11 shown in FIG. 3, the local area 111 and the active device channel area are located on the upper and lower sides of the substrate and opposite to each other, and the hole structures and/or the groove structures are machined only at the local area opposite to every active device channel, as shown in FIG. 6, the dotted line in FIG. 6 defines a plurality of active device channels in the active device channel area, and the gray area in FIG. 6 defines the local area 111 where the hole structures and/or the groove structures are machined out. Preferably, referring to FIG. 4, the local area 111 of the back surface of the substrate 11 is further grinded, so that the thickness of the local area 111 of the substrate is smaller than the thickness of the other area of the substrate 11, so as to further enhance the heat dissipation performance, meanwhile, the thickness of the area other than the local area 111 is maintained to be the grinded global back surface thickness, so that the heat transfer efficiency from the active device channel area to the environment outside the package and the overall structural strength of the gallium nitride device are balanced.

Referring to FIG. 5, after the local area 111 is further thinned, the back surface of the substrate 11 is attached to a packaging chip through conductive solder paste 31.

The preparation method for a gallium nitride device provided by the invention further improves the heat dissipation of the device by processing a hole structure and/or groove structure in the local area of the back surface of the substrate opposite to the active device channel area.

In one embodiment of the invention, the substrate used in the preparation method for a gallium nitride device is a silicon (Si) substrate or a silicon carbide (SiC) substrate, and the hole structure and/or groove structure can be machined at the local area by using a chemical method of wet etching or dry etching and through a standard photoetching processing module of a factory.

In another embodiment of the invention, the substrate used in the preparation method for a gallium nitride device is a sapphire substrate, the thickness of the sapphire substrate before grinding the whole back surface is greater than 300 µm, and the thickness of the sapphire substrate after grinding the whole back surface is between 100 and 300 µm. The thickness of machining location at the local area 111 of the sapphire substrate is less than the thickness of the sapphire substrate after grinding the whole back surface. Compared with other materials (Si, SiC, and GaN), sapphire has the worst thermal conductivity. Any device prepared on a sapphire substrate will inevitably suffer from device performance degradation or even failure induced by heat during normal operation due to excessive heat generated near the active device channel area where high current flows. In this embodiment, the thickness of the machining position at the local area 111 of the sapphire substrate is less than one fifth of the thickness of the sapphire substrate after grinding the whole back surface. For example, the thickness of the machining position at the local area 111 of the sapphire substrate can be further reduced to 1 to 20 µm, obviously, other thicknesses such as 100 µm, 80 µm, 60 µm, 40 µm, or 10 µm can also be selected. The invention improves the heat dissipation performance of the sapphire substrate, by providing the local area after grinding the whole back surface with a thickness less than the thickness of the sapphire substrate after grinding the whole back surface, and the local area and the active device channel area are located at opposite positions on two sides of the substrate (in the thickness direction of the substrate, the projection of the active device channel area covers the projection of the local area), thereby avoiding warping and cracking.

For sapphire substrates, due to the hardness of its material and its inertness to common etching chemistry, it is impractical or very expensive to use common solutions in the wafer fabs. Currently, ultrafast laser beams with ultrashort pulses and ultrahigh power densities are widely used in various industries ranging from ophthalmic surgery to steel cutting to art works. Ultrafast lasers have the unique function of material ablation with ultrashort pulse times (nanoseconds, picoseconds, and femtoseconds) and ultrahigh power densities (>5 Joules/cm²), to cleanly create sub-micron diameter holes/grooves on many dielectrics/ceramics including sapphire, with depths of hundreds of microns. Based on this, the present embodiment proposes to use laser ablation/sublimation (from solid directly to vapor) mechanisms to generate the local area on the sapphire substrate. The hole structures and/or groove structures are generated on the local area by using a pulsed laser with a laser pulse width of 5 femtoseconds to 100 picoseconds and a power density of greater than 3 J/cm². Preferably, the diameter of the hole structures and/or the width of the groove structures generated on the local area are between 0.1 and 1 µm.

In one embodiment of the invention, a gallium nitride HEMT is provided, with silicon or silicon carbide as a substrate, as shown in FIG. 5, which includes a packaging chip and a semiconductor module conductively connected thereto, wherein the semiconductor module includes:
a substrate 11, a back surface thereof being attached to the packaging chip by conductive solder paste;
a buffer layer 12, such as a GaN or AlGaN buffer layer, epitaxially grown on the substrate 1 by MOCVD;
a GaN channel layer 13 grown on the buffer layer 12;
an AlGaN barrier layer 14 grown on the GaN channel layer 13, and a 2DEG 15 formed at a heterojunction interface between the GaN channel layer 13 and the AlGaN barrier layer 14;
a source electrode 21, a drain electrode 22 and a gate electrode 23 of the transistor,
wherein the source electrode 21 and the drain electrode 22 are arranged in the through-grooves of the AlGaN barrier layer 14, and the gate electrode 23 is arranged on the AlGaN barrier layer 14;
a hole structure and/or groove structure is machined at a local area 111 on the back surface of the substrate 11, the substrate 11 is made of silicon or silicon carbide, the hole structure and/or groove structure can be machined at the local area 111 by using a chemical method of wet etching or dry etching, the local area 111 and the active device channel area at the 2DEG 15 are located on the upper and lower sides of the substrate and opposite to each other, the thickness of the machined position at the local area 111 of the substrate is less than half of the thickness of the unmachined position of the substrate; a plurality of active device channels are arranged in the active device channel area; and the hole structures and/or the groove structures is only machined in the local area opposite to every active device channel.

In another embodiment of the invention, a gallium nitride HEMT is provided, which is different from the gallium nitride HEMT with a silicon or silicon carbide substrate provided in the above embodiment, and the gallium nitride HEMT provided in this embodiment adopts a sapphire substrate. In this embodiment, the thickness of the unmachined position of the sapphire substrate is 100 to 300 µm, and the thickness of the machined position at the local area of the sapphire substrate is further thinned based on the poor heat conduction performance of the sapphire, and the thickness of the machined position at the local area of the sapphire substrate is less than one fifth of the thickness of the unmachined position of the sapphire substrate, so as to enhance the heat dissipation performance of the active device channel area.

The specific preparation method of the device can adopt the steps of the embodiment of the method, and details are not described herein.

It is to be noted that, in this document, relational terms such as first and second and the like can be used solely to distinguish one entity or action from another entity or action without necessarily requiring or implying any actual such relationship or order between such entities or actions. Also, the terms "comprises", "comprising" or any other variation thereof, are intended to cover a non-exclusive inclusion, such that a process, method, article, or apparatus that comprises a list of elements does not include only those elements but can include other elements not expressly listed or inherent to such process, method, article, or apparatus. An element proceeded by "comprises one" does not, without more constraints, preclude the existence of additional identical element in the process, method, article, or apparatus that comprises the element.

The above description is only specific embodiments of the present invention. It should be noted that, for those skilled in the art, several improvements and refinements can be made without departing from the principles of the present invention, and these improvements and refinements should also be considered as the protection scope of the present invention.

## Claims

1. A preparation method for a gallium nitride device, comprising the following steps:
epitaxially growing a plurality of layers on a substrate by chemical vapor deposition, an active device channel area being provided between the plurality of layers;
grinding a whole back surface of the substrate;
machining out a hole structure and/or groove structure at a local area of the back surface of the substrate, the local area and the active device channel area being located on upper and lower sides of the substrate and opposite to each other;
attaching the back surface of the substrate to a packaging chip by conductive solder paste.

2. The preparation method for a gallium nitride device of claim 1, wherein the substrate is a sapphire substrate, and a thickness of a machining position at the local area of the sapphire substrate is less than one fifth of a thickness of the sapphire substrate after grinding the whole back surface.

3. The preparation method for a gallium nitride device of claim 2, wherein the hole structure and/or groove structure are machined at the local area by a pulsed laser, so that the thickness of the machining position at the local area of the sapphire substrate is between 1 and 100 µm, or between 1 and 80 µm, or between 1 and 60 µm, or between 1 and 40 µm, or between 1 and 20 µm, or between 1 and 10 µm.

4. The preparation method for a gallium nitride device of claim 3, wherein the hole structure and/or groove structure machined at the local area have a diameter and/or width between 0.1 and 1 µm.

5. The preparation method for a gallium nitride device of claim 3, wherein the pulsed laser has a pulse width between 5 femtoseconds and 100 picoseconds, and a power density greater than 3 J/cm².

6. The preparation method for a gallium nitride device of claim 2, wherein a thickness of the sapphire substrate before grinding the whole back surface is greater than 300 µm, and the thickness of the sapphire substrate after grinding the whole back surface is between 100 µm and 300 µm.

7. The preparation method for a gallium nitride device of claim 1, wherein the substrate is a silicon substrate or a SiC substrate, and the hole structure and/or groove structure are machined at the local area by a chemical method of wet etching or dry etching.

8. The preparation method for a gallium nitride device of any one of claims 1 to 7, wherein a plurality of active device channels are arranged in the active device channel area;
hole structures and/or groove structures are machined only at the local area opposite to every active device channel.

9. The preparation method for a gallium nitride device of any one of claims 1 to 7, wherein the epitaxially growing a plurality of layers on the substrate by chemical vapor deposition comprises:
growing a GaN or AlGaN buffer layer on the substrate;
growing a GaN channel layer on the buffer layer;
growing an AlGaN barrier layer on the GaN channel layer, and forming a 2DEG at a heterojunction interface between the GaN channel layer and the AlGaN barrier layer;
etching down from the AlGaN barrier layer to the GaN channel layer to form two grooves, and arranging a source electrode and a drain electrode in the grooves, respectively; and
arranging a gate electrode on the AlGaN barrier layer.

10. A gallium nitride HEMT, comprising a packaging chip and a semiconductor module conductively connected to the packaging chip, wherein the semiconductor module comprises:
a substrate, a back surface thereof being attached to the packaging chip by conductive solder paste;
a GaN or AlGaN buffer layer epitaxially grown on the substrate by MOCVD;
a GaN channel layer grown on the buffer layer;
an AlGaN barrier layer grown on the GaN channel layer, and a 2DEG being formed at a heterojunction interface between the GaN channel layer and the AlGaN barrier layer;
a source electrode, a drain electrode and a gate electrode of a transistor;
wherein the source electrode and the drain electrode are arranged in through-grooves of the AlGaN barrier layer, and the gate electrode is disposed on the AlGaN barrier layer;
a hole structure and/or groove structure is machined at a local area on a back surface of the substrate, wherein the local area and the active device channel area at the 2DEG are located on upper and lower sides of the substrate and opposite to each other, and a thickness of a machined position at the local area of the substrate is less than half of a thickness of an un machined position of the substrate.

11. The gallium nitride HEMT of claim 10, wherein the substrate is a sapphire substrate, and the thickness of the machined position at the local area of the sapphire substrate is less than one fifth of the thickness of the unmachined position of the sapphire substrate.

12. The gallium nitride HEMT of claim 11, wherein the thickness of the machined position at the local area of the sapphire substrate is between 1 and 100 µm, or between 1 and 80 µm, or between 1 and 60 µm, or between 1 and 40 µm, or between 1 and 20 µm, or between 1 and 10 µm.

13. The gallium nitride HEMT of claim 11, wherein a diameter of the hole structure and/or width of the groove structure machined at the local area is between 0.1 and 1 µm.

14. The gallium nitride HEMT of claim 11, wherein the thickness of the unmachined position of the substrate is between 100 and 300 µm.

15. The gallium nitride HEMT of claim 11, wherein the hole structure and/or groove structure are machined at the local area by a pulsed laser, wherein the pulsed laser has a laser pulse width between 5 femtoseconds and 100 picoseconds, and wherein the pulsed laser has a power density greater than 3 J/cm².

16. The gallium nitride HEMT of claim 10, wherein the substrate is a silicon substrate or a SiC substrate, and the hole structure and/or groove structure are machined at the local area using a chemical method of wet etching or dry etching.

17. The gallium nitride HEMT of any of claims 10 to 16, wherein a plurality of active device channels are arranged in the active device channel area;
hole structures and/or groove structures are machined only at the local area opposite to every active device channel.
